# NOUVEAU FASCICULE DE BREVET EUROPEEN

(11) **EP 2 653 940 B2**
(45) Date de publication et mention de la décision concernant l'opposition: **02.05.2018**
(45) Mention de la délivrance du brevet: 04.03.2015
(21) Numéro de dépôt: 13160295.5
(22) Date de dépôt: 21.03.2013
(51) Int. Cl.: G01R 31/28, G05B 9/02, H01H 47/00

(54) **Système de détection sécurisée**
Gesichertes Erkennungssystem
Secured detection system

(30) Priorité: 18.04.2012 FR 1253581
(43) Date de publication de la demande: 23.10.2013
(73) Titulaire: Schneider Electric Industries SAS, 92500 Rueil-Malmaison (FR)
(72) Inventeur: Auger, Marc, 16800 Soyaux (FR)
(74) Mandataire: Dufresne, Thierry

(56) Documents cités:
- EP-A2- 0 874 437
- WO-A1-92/07374
- DE-A1- 19 935 639
- FR-A1- 2 631 138
- Euchner Systemhandbuch; "Berührungsloser Sicherheitsschalter mit Zuhaltung" 09/2011

## Description

### Domaine technique de l'invention

La présente invention se rapporte à un système de détection sécurisée.

### Etat de la technique

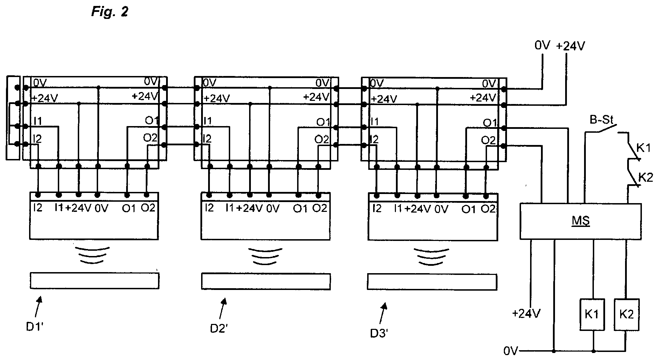

Pour sécuriser l'accès à une machine M située dans un local, il est connu de prévoir un système de détection sécurisée qui permet de ne pas autoriser le démarrage de la machine lorsque le moyen d'accès au local est ouvert. Comme un même local peut comporter plusieurs moyens d'accès, au moins un détecteur est prévu pour sécuriser chaque moyen d'accès. Dans cette situation, les détecteurs sont câblés en chaîne de sorte que les bornes de sortie d'un premier détecteur sont connectées aux bornes d'entrée d'un second détecteur, et ainsi de suite. Ainsi le démarrage de la machine ne sera possible que lorsque toutes les sorties des détecteurs seront actives, c'est-à-dire lorsque tous les moyens d'accès au local seront fermés. Dans les systèmes de détection sécurisée actuels, un module de sécurité MS additionnel est connecté aux bornes de sortie du dernier détecteur de la chaîne et à des moyens de démarrage de la machine. La figure 2 représente une structure chaînée conforme à l'état de la technique. Sur cette figure 2, des organes d'interconnexion sont employés pour connecter les détecteurs D1', D2', D3' entre eux. En bout de chaîne, le module de sécurité MS est connecté aux bornes de sortie du dernier détecteur D3'. Deux relais de commande K1, K2 de la machine et une boucle de retour comportant un bouton de démarrage B-St sont connectés au module de sécurité MS additionnel. Le document WO 92 07374 divulgue un système de détection employé pour sécuriser un démarrage d'une application, comportant des détecteurs connectées de manière à former une chaîne de détection.

Dans l'état de la technique, chaque détecteur est en mode de démarrage automatique par conception. Le module de sécurité additionnel est donc obligatoire pour gérer le démarrage manuel de la machine. Ce module de sécurité additionnel offre certes le choix entre plusieurs modes de démarrage de la machine mais il accroît le coût du système de détection, ainsi que le temps de réponse du système.

Le but de l'invention est de proposer un système de détection comportant plusieurs détecteurs câblés en chaîne et qui ne nécessite pas l'emploi d'un module de sécurité additionnel.

### Exposé de l'invention

Ce but est atteint par un système de détection employé pour sécuriser un démarrage d'une application, ledit système comportant :
- au moins un premier détecteur et un deuxième détecteur, chaque détecteur comportant deux bornes d'entrée connectées à ses entrées logiques, deux bornes de sortie connectées à ses sorties logiques et deux bornes d'alimentation connectées à deux lignes d'alimentation électrique, les deux bornes de sortie du premier détecteur étant connectées aux deux bornes d'entrée du deuxième détecteur,
le système se caractérisant en ce que :
- les deux bornes de sortie du deuxième détecteur sont connectées à des organes de commande de l'application à sécuriser, de manière à former une chaîne de détection,
- le deuxième détecteur comporte une borne d'entrée de démarrage et une borne de sortie de test,
- sur le deuxième détecteur, une boucle de retour est connectée entre la borne d'entrée de démarrage et la borne de sortie de test, en vue d'assurer la surveillance des organes de commande,
- le premier détecteur est configuré dans un mode de démarrage automatique,
- le deuxième détecteur est configuré dans un mode de démarrage manuel, lequel est conditionné à un état actif des entrées du deuxième détecteur, et à une boucle de retour fermée.

Selon l'invention, le premier détecteur et le deuxième détecteur sont identiques.

Selon une autre particularité, le premier détecteur comporte également une borne d'entrée de démarrage connectée à une ligne d'alimentation à potentiel positif et une borne de sortie de test non connectée.

Selon l'invention, les détecteurs sont de type à radio-identification ou de type à effet hall.

Selon une autre particularité, la boucle de retour est commandée par un bouton de démarrage.

Selon l'invention, le système comporte un premier organe d'interconnexion et un deuxième organe d'interconnexion connecté au premier organe d'interconnexion, le premier détecteur étant connecté sur le premier organe d'interconnexion et le deuxième détecteur sur le deuxième organe d'interconnexion.

Selon une autre particularité de l'invention, les organes de commande sont connectés sur le deuxième organe d'interconnexion.

### Brève description des figures

D'autres caractéristiques et avantages vont apparaître dans la description détaillée qui suit faite en regard des dessins annexés dans lesquels :
- la figure 1 illustre le contexte d'utilisation d'un système de détection sécurisée,
- la figure 2 représente un système de détection sécurisée selon l'état de la technique,
- la figure 3 représente le système de détection sécurisée de l'invention.

### Description détaillée d'au moins un mode de réalisation

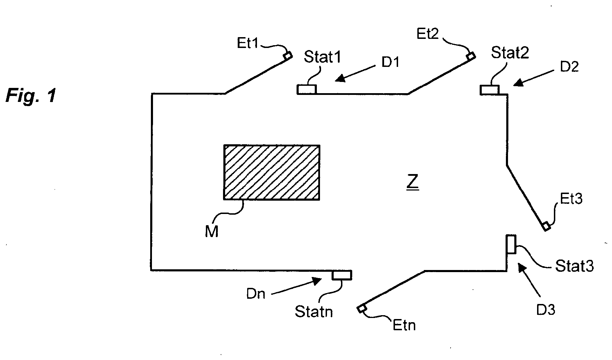

L'invention concerne un système de détection sécurisée. Un tel système de détection sécurisée est par exemple employé pour sécuriser le démarrage d'une application, par exemple d'une machine, située dans un local Z. La figure 1 illustre cet exemple. Le système de détection sécurisée comporte plusieurs détecteurs D1, D2, D3, ... Dn connectés en chaîne, chaque détecteur étant dédié à la surveillance d'un moyen d'accès au local Z. Le démarrage de la machine M n'est possible que si toutes les sorties des détecteurs sont actives, c'est-à-dire lorsque tous les moyens d'accès au local sont fermés.

Les détecteurs sont par exemple de type à radio-identification (ci-après RFID). Bien entendu, d'autres technologies que la RFID pourraient être employées, comme par exemple la détection par effet hall, optique ou avec des contacts magnétiques. Dans la suite de la description, nous nous intéresserons à des détecteurs de type RFID.

Dans le contexte illustré par la figure 1, une étiquette Et1, Et2, Et3 électronique RFID est par exemple fixée au moyen d'accès, tandis qu'une station de lecture/écriture Stat1, Stat2, Stat3 est fixée sur le bâti du moyen d'accès. Lorsque l'étiquette Et1, Et2, Et3 électronique RFID se trouve dans le champ de la station, cela signifie que le moyen d'accès est fermé et donc que les sorties du détecteur sont actives.

Comme discuté ci-dessus, dans l'état de la technique représenté sur la figure 2, un module de sécurité MS additionnel est connecté en bout de chaîne. Ce module de sécurité MS additionnel gère le mode de démarrage de la machine M et surveille la boucle de retour Br, c'est-à-dire l'état des relais de commande K1, K2 de la machine. L'invention vise à supprimer ce module de sécurité additionnel de la chaîne de détection.

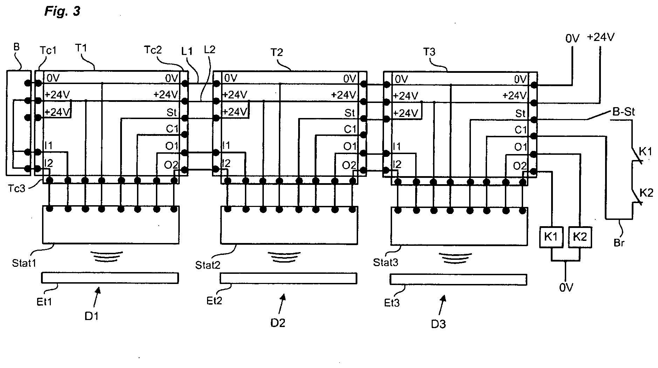

Dans la suite de la description, on considérera une chaîne de détection qui comporte un nombre n de détecteurs, n étant supérieur ou égal à deux. Le détecteur de rang n est situé au bout de la chaîne de détection. Sur la figure 3, seuls trois détecteurs D1, D2, D3 sont représentés.

Selon l'invention, chaque détecteur comporte deux bornes d'entrée I1, I2 connectées sur ses entrées logiques, deux bornes de sortie 01, 02 connectées sur ses sorties logiques, deux bornes d'alimentation (0V, +24V), une borne d'entrée de démarrage St et une borne de sortie de test C1.

Dans le système de détection sécurisée, les bornes de sortie 01, 02 du détecteur de rang 1 sont connectées aux bornes d'entrée I1, I2 du détecteur de rang 2, les bornes de sortie 01, 02 du détecteur de rang 2 sont connectées aux bornes d'entrée I1, I2 du détecteur de rang 3 et ainsi de suite. Les bornes de sortie 01, 02 du détecteur de rang n-1 sont ainsi connectées aux bornes d'entrée du détecteur de rang n.

Les deux bornes d'alimentation (0V, +24V) de chaque détecteur de la chaîne sont connectées à deux lignes d'alimentation s'étendant sur toute la longueur de la chaîne et connectées à une source d'alimentation. La première ligne d'alimentation L1 est à un potentiel électrique nul et la deuxième ligne d'alimentation L2 est à un potentiel électrique positif, par exemple fixé à +24 Volts.

Selon l'invention, les détecteurs de rang 1 à n-1 sont configurés en mode de démarrage automatique, c'est-à-dire que l'activation de leurs sorties n'est pas conditionnée à la fermeture manuelle d'une boucle connectée sur leur borne d'entrée de démarrage St. Pour configurer ces détecteurs en mode de démarrage automatique, leur borne d'entrée de démarrage St est connectée sur la deuxième ligne d'alimentation L2. Le chaînage des détecteurs réalise cette configuration. Dans ce mode de démarrage automatique, l'étiquette RFID de chaque détecteur doit être à portée du lecteur pour activer les sorties logiques.

Selon l'invention, les bornes de sortie 01, 02 du détecteur de rang n sont connectées à des organes de commande de la machine M, constitués de deux relais K1, K2. La boucle de retour Br, permettant de surveiller l'état des deux relais K1, K2, est connectée entre la borne d'entrée de démarrage St et la borne de sortie de test C1 du détecteur de rang n. Le bouton de démarrage de la machine est placé sur cette boucle de retour Br. Le démarrage de la machine M est effectué en appuyant sur le bouton de démarrage et n'est possible que si les sorties du détecteur de rang n sont actives et si la boucle de retour Br est fermée.

Selon l'invention, pour réaliser le câblage entre deux détecteurs de la chaîne, on utilise par exemple deux organes d'interconnexion, en forme de T. La figure 3 montre une telle solution. Un organe d'interconnexion est associé à chaque détecteur de la chaîne. Ainsi, le système de détection comporte également n organes d'interconnexion identiques. Bien entendu, il serait possible de se passer des organes d'interconnexion, en intégrant, dans chaque détecteur, la configuration de câblage réalisée par chacun des organes d'interconnexion.

Les organes d'interconnexion T1, T2, T3 sont agencés pour assurer la continuité des lignes d'alimentation L1, L2, connecter les bornes de sortie 01, 02 d'un détecteur sur les bornes d'entrée I1, I2 du détecteur suivant et permettre aux détecteurs des rangs 1 à n-1 de fonctionner en mode de démarrage automatique en connectant leur borne d'entrée de démarrage St à la deuxième ligne d'alimentation L2. La boucle de retour Br commandée par le bouton de démarrage B-St est connectée entre la borne d'entrée de démarrage St et la borne de sortie de test C1 du détecteur de rang n, via l'organe d'interconnexion de rang n.

Chaque organe d'interconnexion T1, T2, T3 comporte un connecteur amont Tc1, un connecteur aval Tc2 et un connecteur intermédiaire Tc3. Le détecteur est connecté sur le connecteur intermédiaire de l'organe d'interconnexion, tandis que le connecteur aval d'un organe d'interconnexion de rang 1 est connecté sur le connecteur amont de l'organe d'interconnexion de rang 2 et ainsi de suite jusqu'au rang n.

Par ailleurs, un bouchon de début de chaîne est par exemple positionné sur l'organe d'interconnexion de rang 1. Ce bouchon B permet de connecter les bornes d'entrée I1, I2 du détecteur de rang 1 sur la deuxième ligne d'alimentation L2, ce qui fixe automatiquement les entrées physiques au potentiel électrique positif. Dans cet état, les entrées sont dites actives.

Bien entendu, des câbles à cinq fils sont employés pour réaliser la jonction entre les organes d'interconnexion.

En fonctionnement, si tous les moyens d'accès sont fermés, les sorties des détecteurs des rangs 1 à n-1 sont actives et les entrées du détecteur de rang n, situé en bout de chaîne, sont alors actives. Les sorties du détecteur de rang n seront actives si la boucle de retour Br est fermée, c'est-à-dire si les deux relais de surveillance K1, K2 sont fermés, si l'étiquette RFID est à portée du lecteur et si le bouton de démarrage B-St a été enclenché.

Le système de détection sécurisée de l'invention présente ainsi plusieurs avantages, listés ci-dessous :
- Il permet d'éviter l'emploi d'un module de sécurité additionnel, tout en conservant le mode de démarrage manuel et la surveillance de la boucle de retour Br.
- Chaque détecteur peut fonctionner en mode de démarrage automatique ou en mode de démarrage manuel. La configuration de chaque détecteur est réalisée de manière transparente pour l'utilisateur, juste par câblage des détecteurs.
- Tous les détecteurs du système sont identiques, quelle que soit leur position dans la chaîne.
- Selon la configuration de câblage du détecteur, le système de détection de l'invention peut être imaginé avec ou sans organe d'interconnexion.

Selon l'invention, afin de proposer des modes de démarrage supplémentaires et/ou des capacités de commutation supplémentaires, il est possible d'employer un module de sécurité MS additionnel tel que celui représenté sur la figure 2. Le module de sécurité MS serait alors connecté sur les deux sorties du détecteur de rang n situé en bout de chaîne, par exemple via un organe d'interconnexion. Le détecteur de rang n serait alors configuré en démarrage automatique. Le module de sécurité gérerait la boucle de retour et l'activation des relais de commande K1, K2.

## Revendications

1. Système de détection employé pour sécuriser un démarrage d'une application, ledit système comportant :
- au moins un premier détecteur (D2) et un deuxième détecteur (D3), chaque détecteur comportant deux bornes d'entrée (I1, I2) connectées à ses entrées logiques, deux bornes de sortie (O1, O2) connectées à ses sorties logiques et deux bornes d'alimentation (0V, +24V) connectées à deux lignes d'alimentation électrique, les deux bornes de sortie (O1, O2) du premier détecteur (D2) étant connectées aux deux bornes d'entrée (I1, I2) du deuxième détecteur (D3),
- les deux bornes de sortie (O1, O2) du deuxième détecteur (D3) sont connectées à des organes de commande (K1, K2) de l'application à sécuriser, de manière à former une chaîne de détection,
**caractérisé en ce que** :
- le deuxième détecteur (D3) comporte une borne d'entrée de démarrage (St) et une borne de sortie de test (C1),
- sur le deuxième détecteur (D3), une boucle de retour (Br) est connectée entre la borne d'entrée de démarrage (St) et la borne de sortie de test (C1), en vue d'assurer la surveillance des organes de commande,
- le premier détecteur (D2) est configuré dans un mode de démarrage automatique, et est connectée à l'entrée de démarrage sur la deuxième ligne d'alimentation à potentiel positif,
- le deuxième détecteur (D3) est configuré dans un mode de démarrage manuel, lequel est conditionné à un état actif des entrées du deuxième détecteur (D3), et à la boucle de retour (Br) fermée,
- la boucle de retour (Br) est commandée par un bouton de démarrage (B-St).

2. Système selon la revendication 1, **caractérisé en ce que** le premier détecteur (D2) et le deuxième détecteur (D3) sont identiques.

3. Système selon la revendication 2, **caractérisé en ce que** le premier détecteur comporte également une borne d'entrée de démarrage (St) connectée à une ligne d'alimentation (L2) à potentiel positif et une borne de sortie de test non connectée.

4. Système selon l'une des revendications 1 à 3, **caractérisé en ce que** les détecteurs sont de type à radio-identification.

5. Système selon l'une des revendications 1 à 3, **caractérisé en ce que** les détecteurs sont de type à effet hall.

6. Système selon l'une des revendications 1 à 5, **caractérisé en ce qu'**il comporte un premier organe d'interconnexion (T2) et un deuxième organe d'interconnexion (T3) connecté au premier organe d'interconnexion (T2), le premier détecteur (D2) étant connecté sur le premier organe d'interconnexion (T2) et le deuxième détecteur (D3) sur le deuxième organe d'interconnexion (T3).

7. Système selon la revendication 6, **caractérisé en ce que** les organes de commande (K1, K2) sont connectés sur le deuxième organe d'interconnexion (T3).

## Patentansprüche

1. Detektionssystem, das verwendet wird, um ein Starten einer Anwendung zu sichern, wobei das System Folgendes umfasst:
- wenigstens einen ersten Detektor (D2) und einen zweiten Detektor (D3), wobei jeder Detektor zwei Eingangsanschlüsse (I1, I2), die mit seinen logischen Eingängen verbunden sind, zwei Ausgangsanschlüsse (O1, O2), die mit seinen logischen Ausgängen verbunden sind, und zwei Versorgungsanschlüsse (0 V, +24 V), die mit zwei Stromversorgungsleitungen verbunden sind, aufweist, wobei die zwei Ausgangsanschlüsse (O1, O2) des ersten Detektors (D2) mit den zwei Eingangsanschlüssen (I1, I2) des zweiten Detektors (D3) verbunden sind,
- wobei die zwei Ausgangsanschlüsse (O1, O2) des zweiten Detektors (D3) mit Steuerorganen (K1, K2) der zu sichernden Anwendung verbunden sind, derart, dass eine Detektionskette gebildet wird,
**dadurch gekennzeichnet, dass**:
- der zweite Detektor (D3) einen Start-Eingangsanschluss (St) und einen Test-Ausgangsanschluss (C1) umfasst,
- bei dem zweiten Detektor (D3) zwischen den Start-Eingangsanschluss (St) und den Test-Ausgangsanschluss (C1) eine Rückkehrschleife (Br) geschaltet ist, um die Überwachung der Steuerorgane sicherzustellen,
- der erste Detektor (D2) für einen Modus für automatischen Start konfiguriert ist, und mit dem Start-Eingangsanschluss an der zweiten Stromversorgungsleitung mit positivem Potential verbunden ist,
- der zweite Detektor (D3) für einen Modus für manuellen Start konfiguriert ist, der durch einen aktiven Zustand der Eingänge des zweiten Detektors (D3) und durch eine geschlossene Rückkehrschleife (Br) bedingt ist,
- die Rückkehrschleife (Br) durch einen Startknopf (B-St) gesteuert wird.

2. System nach Anspruch 1, **dadurch gekennzeichnet, dass** der erste Detektor (D2) und der zweite Detektor (D3) gleich sind.

3. System nach Anspruch 2, **dadurch gekennzeichnet, dass** der erste Detektor außerdem einen Start-Eingangsanschluss (St), der mit einer Versorgungsleitung (L2) mit positivem Potential verbunden ist, und einen Test-Ausgangsanschluss, der nicht angeschlossen ist, aufweist.

4. System nach einem der Ansprüche 1 bis 3, **dadurch gekennzeichnet, dass** die Detektoren vom Funkidentifizierungstyp sind.

5. System nach einem der Ansprüche 1 bis 3, **dadurch gekennzeichnet, dass** die Detektoren vom Hall-Effekt-Typ sind.

6. System nach einem der Ansprüche 1 bis 5, **dadurch gekennzeichnet, dass** es ein erstes Verbindungsorgan (T2) und ein zweites Verbindungsorgan (T3), das mit dem ersten Verbindungsorgan (T2) verbunden ist, umfasst, wobei der erste Detektor (D2) mit dem ersten Verbindungsorgan (T2) verbunden ist und der zweite Detektor (D3) mit dem zweiten Verbindungsorgan (T3) verbunden ist.

7. System nach Anspruch 6, **dadurch gekennzeichnet, dass** die Steuerorgane (K1, K2) mit dem zweiten Verbindungsorgan (T3) verbunden sind.

## Claims

1. Detection system employed for securing a start-up of an application, said system comprising:
- at least one first detector (D2) and one second detector (D3), each detector comprising two input terminals (I1, I2) connected to its logic inputs, two output terminals (O1, O2) connected to its logic outputs and two power supply terminals (0V, +24V) connected to two electrical power supply lines, the two output terminals (O1, O2) of the first detector (D2) being connected to the two input terminals (I1, I2) of the second detector (D3),
- the two output terminals (O1, O2) of the second detector (D3) are connected to control devices (K1, K2) of the application to be secured, so as to form a detection chain,
**characterized in that**:
- the second detector (D3) comprises a start-up input terminal (St) and a test output terminal (C1),
- to the second detector (D3), a feedback loop (Br) is connected between the start-up input terminal (St) and the test output terminal (C1), for the purpose of monitoring the control devices,
- the first detector (D2) is configured in an automatic start-up mode, and is connected to the start-up input on the second positive potential power supply line,
- the second detector (D3) is configured in a manual start-up mode, which is conditional upon an active state of the inputs of the second detector (D3), and on a closed feedback loop (Br),
- the feedback loop (Br) is controlled by a start-up button (B-St).

2. System according to Claim 1, **characterized in that** the first detector (D2) and the second detector (D3) are identical.

3. System according to Claim 2, **characterized in that** the first detector also comprises a start-up input terminal (St) connected to a positive potential power supply line (L2) and an unconnected test output terminal.

4. System according to one of Claims 1 to 3, **characterized in that** the detectors are of the radio-identification type.

5. System according to one of Claims 1 to 3, **characterized in that** the detectors are of the Hall-effect type.

6. System according to one of Claims 1 to 5, **characterized in that** it comprises a first interconnection device (T2) and a second interconnection device (T3) connected to the first interconnection device (T2), the first detector (D2) being connected to the first interconnection device (T2) and the second detector (D3) to the second interconnection device (T3).

7. System according to Claim 6, **characterized in that** the control devices (K1, K2) are connected to the second interconnection device (T3).
